Europäisches Patentamt

European Patent Office

Office européen des brevets

(11) Publication number: **0 097 815**
**B1**

(12) **EUROPEAN PATENT SPECIFICATION**

(45) Date of publication of patent specification: **07.12.88**

(51) Int. Cl.⁴: **H 05 K 7/06, C 09 J 3/16**

(21) Application number: **83105164.4**

(22) Date of filing: **25.05.83**

(54) Photocurable adhesive and circuit board employing same.

(30) Priority: **28.06.82 US 392997**

(43) Date of publication of application:
**11.01.84 Bulletin 84/02**

(45) Publication of the grant of the patent:
**07.12.88 Bulletin 88/49**

(84) Designated Contracting States:
**DE FR GB**

(56) References cited:
**EP-A-0 012 542**
**US-A-4 169 732**

**NEW ELECTRONICS, vol. 15, no. 2, January 1982, pages 73-74, London (GB); N.K. PEARNE: "Automatic discrete wiring".**
**IBM TECHNICAL DISCLOSURE BULLETIN, vol. 20, no. 7, December 1977, page 2609, New York (USA); E.R. SKARVINKO: "Light-sensitive epoxy composition".**

(73) Proprietor: **International Business Machines Corporation**
**Old Orchard Road**
**Armonk, N.Y. 10504 (US)**

(72) Inventor: **Rudik, William John**
**RD No. 1, Box 385A**
**Vestal New York 13850 (US)**
Inventor: **Schmitt, George Pershing**
**928 Cherry Lane**
**Vestal New York 13850 (US)**
Inventor: **Shipley, John Frank**
**3725 Frazier Drive**
**Endwell New York 13760 (US)**

(74) Representative: **Burt, Roger James, Dr.**
**IBM United Kingdom Limited Intellectual Property Department Hursley Park**
**Winchester Hampshire SO21 2JN (GB)**

## Description

The present invention relates to photocurable adhesives and to circuit boards for electronic components employing same and more particularly to so-called encapsulated wire circuit boards.

The art of making circuit boards is well developed. The technique most widely used to fabricate circuit boards is generally referred to as the subtractive processes. This process begins with a sheet of copper on a substrate. The copper sheet is etched to form a pattern of desired circuit paths. A more advanced technique for fabricating circuit boards is termed the additive process. The additive process begins with an insulating substrate and adds copper where needed to form the desired circuit lines. One way of practising the additive process to fabricate circuit boards is described in US—A—4,030,190.

An alternative way to fabricate circuit boards involves encapsulating insulated wires in an adhesive. The resulting circuit board is generally termed an encapsulated wire circuit board. Encapsulated wire circuit boards are commercially available under the trade name "Multiwire" which is owned by the Kollmorgen Corporation. The encapsulated wire technique is shown in U.S. Patents 4,097,684 (Burr); 3,646,772 (Burr); 3,674,914 (Burr) and 3,674,602 (Keough).

EP—A—0097814, published after the priority date of this application, describes a technique for making an encapsulated wire circuit board wherein the insulated wires are firmly bonded to a relatively thick layer of copper which is covered by a layer of pre-preg. The expansion and contraction of the board during thermal cycling is controlled by the copper and therefore there is not any significant amount of unpredictable variations in the dimensions of the board. Holes can be very accurately drilled at precise locations in such boards. In the technique described, insulated wires are bonded to a substrate utilizing a heat curable adhesive so that after the adhesive is cured the wires cannot move relative to the substrate.

EP—A—0097817, published after the priority date of this application, describes an improvement of the circuit board and process described in EP—A—0097814, namely the fabrication of an encapsulated wire board using a photo-curable adhesive material. In this technique, the wires are laid in a photo-curable adhesive, this adhesive is exposed to light, thereby curing the adhesive and firmly bonding the wires to the substrate. EP—A—0097817 describes the use of the material disclosed in US—A—4,169,732, which does not have the unique combination of rheological properties of the photo-curable material required to practice the present invention. It further suggests the use of the adhesive described in this application.

The present invention provides an improved photo-curable adhesive which has a unique combination of rheological properties. Encapsulated wire circuit boards using the adhesive in accordance with the present invention can be fabricated efficiently due to the unique combination of rheological properties of the adhesive. These same rheological properties give encapsulated circuit boards made in accordance with the present invention a high degree of dimensional stability. Thus, the present invention both facilitates the manufacturing operation and results in an improved encapsulated wire circuit board.

It is known that the rheological properties of viscoelastic materials can be described in terms of the responses to sinusoidal inputs. For example, see the text Applied Mathematical Sciences, Vol. 7, entitled "Lectures on Viscoelasticity Theory" by A C Pipkin 1972 (Library of Congress Catalog Card No. 74—186996). The adhesive material of this invention is described in this way using the conventional Storage Shear Modulus (i.e. G'), the conventional Loss Shear Modulus (i.e. G'') and the ratio of G'' to G' herein termed the Loss Angle Ratio.

According to the invention, a photo-curable adhesive is characterised by having the following rheological properties:

1) a Loss Angle Ratio at ambient temperature which is between 0.1 and 1, and preferably between about 0.3 and 0.7;

2) a Storage Shear Modulus G' at ambient temperature which is between $10^7$ and $10^8$, and preferably between about $2 \times 10^7$ and $4 \times 10^7$; and

3) the Storage Shear Modulus G' at temperatures above ambient and below 150°C being less than $10^6$.

We have found that using a photocurable adhesive with this unique combination of rheological properties results in an encapsulated wire board which is easy to fabricate and which has great dimensional stability.

Wires are embedded in this adhesive using a conventional wiring apparatus of the type generally shown in US—A—3,674,602. After the wires have been laid in the photocurable adhesive, the adhesive is partially cured by illuminating it with light. Next, the adhesive is thermally cured, either by heat alone or as part of a high temperature laminating step. A conventional drilling operation then follows. The holes are plated and the board is finished in a conventional manner.

The invention also provides an encapsulated wire circuit board consisting of a rigid base plane, a layer of glass epoxy pre-preg covering said base plane, and insulated wires encapsulated in a layer of photo-cured adhesive covering said epoxy pre-preg, the adhesive being a photocurable adhesive according to the invention.

The invention will now be further described with reference to the accompanying drawings, in which:—

Figure 1 illustrates a layer of copper foil showing the power clearance holes;

Figure 2 illustrates a composite containing a plurality of power cores;

Figure 3 illustrates a composite including the layers of adhesive; and

Figure 4 illustrates a composite with wires applied, the wires being shown on the surface for clarity.

EP 0 097 815 B1

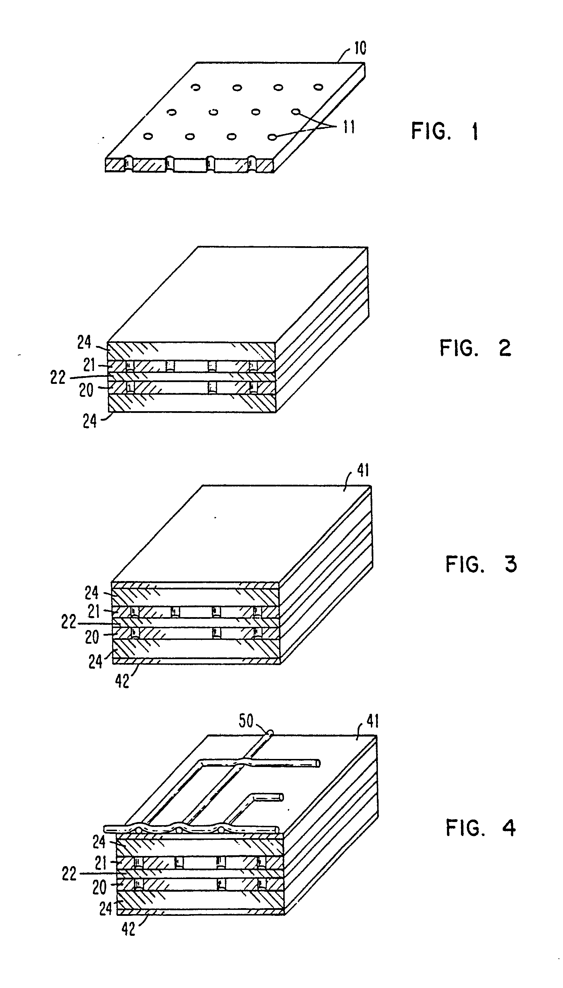

The base element in circuit boards fabricated in accordance with this invention is a layer of copper foil 10 shown in Figure 1. This can be what is commonly called two ounce copper which has a weight of two ounces per square foot. The circuit board can include one or more such layers. The foil forms a ground or power plane for the circuit board. Holes 11 are drilled in this foil at all locations where connections will be made to the encapsulated wires (except at the locations where connections between the encapsulated wires and the power or ground planes are desired).

The particular embodiment shown here has a power plane 20 and a ground plane 21 in each composite as shown in Figure 2. Power plane 20 and ground plane 21 are separated by a layer of epoxy resin pre-preg 22 and covered by layers of epoxy pre-preg 23 and 24. Epoxy resin pre-preg 22, 23 and 24 is conventional pre-preg which consists of glass cloth impregnated with epoxy. The epoxy pre-preg can for example be formulated as shown in U.S. Patent 4,024,305.

The top and bottom layers of pre-preg 23 and 24 are covered with layers of adhesive 41 and 42 as shown in Figure 4. The photo-curable adhesive 41 and 42 must have the following rheological properties:

The adhesive must be photo-curable to a gelled state so that once it is cured it is not soluble in non-degrading solvents such as ketones, aromatic hydrocarbons, or ether-alcohols.

The adhesive must have the following rheological properties (measured at a frequency in the range of 1 to 10 cycles per second):

1) a Loss Angle Ratio at ambient temperature which is:
   greater than about one tenth, less than about one
   and preferably about three tenths to seven tenths.

2) a Storage Shear Modulus G' at ambient temperature which is:
   greater than about ten to the seventh power,
   less than about ten to the eight power, and
   preferably about (2 to 4) times ten to the seventh power.
   (Units of G' are dynes per cm. squared—dyne per $cm^2 = 10^{-1}$ Pa)

3) a Storage Shear Modulus G' at temperatures of
   less than 150 degrees centigrade which is:
   less than about ten to the sixth power.

If the adhesive material does not have the above combination of rheological properties, the quality of the resultant circuit board and the ease of wiring will be reduced. Prior to the present invention it was not recognized that the above combination of rheological provided an advantage and there was no existing photocurable adhesive that had this unique combination of rheological properties. A particular adhesive that displays this unique combination of rheological properties is described in detail hereinafter; however, any photocurable adhesive which displays this combination of rheological properties can be used.

The circuit wires 50 are embedded in the adhesive 41 and 42 as shown in Figure 4. This can be done utilizing the type of equipment marketed by Kollmorgen Corporation for the fabrication of "Multiwire" boards. An example of such machinery is described in U.S. Patent 3,674,914 (Burr).

If a multilayer board is desired, several composites each of which has wires applied as described above can be laminated together to form a multilayer board. The number of composites that can be laminated together is among other considerations limited by the ability to accurately drill small holes through the entire assembly.

A photo-curable adhesive which meets the requirements of the present invention can be formed using:
   1) a Bisphenol A-based epoxy resin having a molecular weight of about 1500 to 5000,
   2) a highly functional epoxidized novolac having a molecular weight of about 900 to 1500,
   3) monoethylenically unsaturated carboxylic acid
   4) a catalyst
   5) a polyethylenically unsaturated compound
   6) a photoinitiator
   7) a phenoxy resin, and
   8) a thixotropic agent
The following describes how a particular photo-curable adhesive that has the unique combination of rheological properties required by the present invention can be obtained.

First, form a pre-polymer from:
   1) a bisphenol A-based epoxy resin having a molecular weight of about 1500 to 5000 such as for example Epon 1004 marketed by Shell Chemical Co.
   2) a completely or highly functionalized epoxidized novolac having a molecular weight of about 900 to 1500 such as for example Dow 485 marketed by Dow Chemical Co.
   The epoxies (1) and (2) can be in a ratio of (4:1) to (1:4). A ratio of 1 to 1 is preferred.
   3) a monoethylenically unsaturated carboxylic acid such as acrylic acid, methacrylic acid or crotonic acid. There should be sufficient acid to react approximately 20 to 100 percent of the epoxide functional

3

EP 0 097 815 B1

groups. An amount sufficient to react seventy five percent is preferred (one mole per group for the reaction).

4) a catalyst such as a tertiary amine (for example BDMA, benzyl dimethylamine or TMBDA, tetra methyl butane diamine) or heavy metal salts such as stannous octoate or lead naphthanate. The catalyst enhances the esterification reaction of the acid and epoxy. It determines the speed of the esterification reaction. The mixture must be cooked longer if one has less of this compound in the mixture.

A diluent such as 2-ethoxyethylacetate (available under the tradename Cellosolve Acetate) or 2-(2-butoxyethoxy) ethanol (available under the tradename Butyl Carbitol) is used to obtain an acceptable viscosity. An amount sufficient to get the desired consistency for film casting should be used. An amount of diluent sufficient to obtain a viscosity in the range of about 1000 to 2200 centipoise has been found to be satisfactory for film casting. The amount of diluent used is not critical to the composition.

As described herein the adhesive material is applied to a film carrier which is laminated to the circuit board and then the carrier is removed. Alternatively the adhesive could be sprayed onto the circuit board or it could be applied by a knife coating technique. If spraying is used an amount of diluent sufficient to obtain a viscosity up to about 1000 centipoise should be used. If knife edge coating is used, an amount of diluent sufficient to obtain a viscosity of above about 2200 centipoise should be used.

Other diluents which can be used are for example:

methyl cellosolve acetate (methoxyethyl acetate)
ethyl cellosolve acetate (ethoxyethyl acetate)
propyl cellosolve acetate (propoxyethyl acetate)
butyl cellosolve acetate (butoxyethyl acetate)
butyl carbitol 2-(2-butoxyethoxy) ethanol
diethyl carbitol bis(2-ethoxy ethyl) ether
methylene chloride-methanol (azeotrope)
methyl ethyl ketone

Form the pre-polymer by cooking the above. The desired reaction conditions for such a reaction are well known and need not be described herein in any great detail. For example, temperatures of about normal room temperature to about 75 degrees C. are suitable. Times of pre-reaction of 30 minutes and up have been found to be quite adequate.

After the above pre-polymer has been formed add the following:

1) A photoinitiator or catalyst (such as for example TBA, tertiary butylanthroquinone); This photoinitiator or catalyst determines how many active centers will be present in the mixture when exposured to U.V. or other actinic radiation. Examples of some other suitable photoinitiators include substituted anthraquinones such as alkyl substituted or halo substituted anthraquinones including 2-tert-butylanthraquinone; other substituted or unsubstituted polynuclear quinones including 1,4-napthaquinone, 9,10-phenanthraquinone, 1,2-benzanthraquinone, 2,3-dichloronaphthaquinone, and 1,4-dimethylanthraquinone. Other photo-sensitizers include halogen-type sensitizers such as carbontetrachloride, bromoform and carbontribromide; benzotriazole; benzoin, chloranil, benzil, diacetyl, 5-nitrosal- icylaldehyde, and 2,4-dinitrotoluene. Mixtures of photoinitiators can be employed when desired. The preferred photoinitiators include the anthraquinones such as tert- butyl anthraquinone. The photoinitiator is employed in amounts sufficient to sensitize the composition to ultraviolet light and is generally from about 0.1 to about 10% and preferably from about 0.1 to about 5% of the non-volatiles of the composition.

2) A polyethylenically unsaturated compound (such as for example TMPTA, Trimethylolpropane-triacrylate); This material in essence determines how successful each activation will be. As more of this material is added, the resultant material will cure faster with actinic radiation. This material also softens the resultant photo curable adhesive. The amount of polyethylenically unsaturated compound employed is about 10 to about 25 percent by weight of the non-volatiles of the composition. Other suitable polyethylenically unsaturated compounds include unsaturated esters of polyols and especially esters of the methylene carboxylic acid such as ethylene diacrylate; diethylene glycol diacrylate; glycerol diacrylate; glycerol triacrylate; ethylene dimethacrylate; 1,3-propylene dimethacrylate; 1,2,4-butene triol trimethacrylate; 1,4-benzenediol dimethacrylate; pentaerythriol tetramethacrylate; 1,3-propane diol diacrylate; 1,6-hexane diol diacrylate; the bis-acrylates and methacrylates of polyethylene glycols of molecular weight 200—500; trimethylol propane triacrylate; pentaerythritol triacrylate; unsaturated amides such as those of the methylene carboxylic acids such as methylene bisacryl and bismethacrylamide; vinyl-esters such as divinyl succinate; divinyl adipate; divinyl phthalate, and divinyl terephthalate, and unsaturated aldehydes such as sorbaldehyde.

3) A relatively high molecular weight phenoxy polymer having a molecular weight of about 30,000 to about 200,000. This phenoxy polymer is preferably a bisphenol A-based phenoxy and most preferably a bisphenol A-epichlorophdrin phenoxy. Some commercially available phenoxy polymers include for example PKHC resin commercially available from Union Carbide. Other examples are Eponol 53, and Eponol 55 which are commercially available from Shell Chemical Corp. The molecular weight of these compounds is so high that for practical purposes one need not consider their terminal epoxide functionality. This epoxy makes the Young's modulus of the coating higher and broadens the Loss Angle

4

ratio peak. The phenoxy polymer is employed in amounts of about 15 to 40 and preferably 20 to 30 percent by weight of the non volatile components of the composition.

4) A thixotropic or thickening agent such as for example fumed or colloidal silica. Colloidal silica is silica having a surface area of about 50 to about 500 M-2/gram (determined by the BET nitrogen adsorption material) with particles having diameters from about 5 to about 20 mm. Colloidal silica, used according to the present invention, is preferably fused silica gel or fused silicon dioxide as it is sometimes called. In addition, the colloidal silica is often referred to in the art as silica aerogel. Fused silica is obtained by the hydrolysis or combustion of silicon tetrachloride in hydrogen- oxygen furnaces. Examples of some commercially available colloidal silicas include CAB-O-SIL and Santocel. The silica is employed in amounts of about 2 to about 20 percent and preferably about 4 to about 18 percent by weight based upon the non-volatile content of the composition. Carbon black, or bentonite clay are other examples of thixotropic agents that may be used.

The composition can, but does not necessarily, contain auxiliary agents such as storage stabilizers and surfactants. For example the composition can include:

Benzoquinone: This compound provides shelf life. It has the effect of inhibiting polymerization during storage. It is not required for the practice of this invention.

FC 430—this is a surfactant to enhance coating the film to make it smoother. It is not required to practice the invention.

The following is a specific example of how an adhesive having the required properties can be formulated:

The following mixture is allowed to react at about 60 degrees Celcius for about 20 hours.

a 50 percent solution of about 700 parts by weight of 2-ethoxyethylacetate (available under the tradename Cellosolve Acetate) and a solid bisphenol A-epichlorohydrin epoxy resin which has a molecular weight in the range of about 1500 to 5000 (for example Epon resin 1004 which has a molecular weight of about 1750). and

a 50 percent solution of about 700 parts by weight of 2-ethoxyethylacetate (available under the tradename Cellosolve Acetate) and a solid epoxidized novolac resin which has a molecular weight in the range of about 900 to 1500 (such as for example Dow DEN 485 which has a molecular weight of about 1100)

about 114 parts by weight of acrylic acid and

about 7 parts by weight of benzyl dimethylamine as a promoter.

Note: The above is sufficient acrylic acid to react 75 percent of the epoxide functional groups since:

350 parts of Dow 485 divided by epoxide equivalent weight of 200=1.75

350 parts of Epon 1004 divided by epoxide equivalent weight of 950=.37

Total times 75 percent (1.75 plus .37 times .75=1.59)

times molecular weight of acrylic acid (1.59 times 72=114)

After the above prepolymer is formed take 776 parts of the resultant prepolymer and add the following:

about 1000 parts of a 29.5 percent solution of phenoxy resin (available under the tradename PKHC from Union Carbide) in 2-ethoxy ethylacetate (available under the trade name Cellosolve Acetate).

about 80 parts of fumed silica (available under the trade name CAB-O-SIL)

disperse the CAB-O-SIL by mixing in a planetary mixer

To the above add:

about 204 parts of TMPTA

about 12.3 parts of TBA

about 2.8 parts of FC 430

about .1 gram of Benzoquinone

about 526 parts of Cellosolve Acetate,

Blend the result in a planetary mixer until uniformly mixed.

The resulting composition is coated onto one side of a polyester sheet such as a polyethyleneterephthalate sheet (available under the trade name Mylar) and passed through an oven maintained at about 127°C (260 degrees F.) at a speed of about 3.5 to 13 metres/minute 10 to 40 feet/minute. 7.66 metres/minute (22 feet/minute) is preferred). An amount is applied to the film such that the resulting dry films has a thickness of 0.076 mm (3 mils).

The coated sheet is applied to a laminate as shown in Figure 3. The polyethyleneterephthalate is next peeled from the coated composite. Wires are then applied using conventional encapsulated wire techniques. The wiring takes place at an ambient temperature of about twenty five degrees Celsius.

After the wiring operation is complete the wires are pressed further into the adhesive by laminating the composite under a pressure of about 1.17210869 MPa (170 psi) for about 30 minutes.

The coating is then thoroughly exposed using conventional actinic radiation (for example using carbon arc, high pressure mercury lamps etc.

In order to ensure that the composite is sufficiently cured the resulting composite can be post-cured at about 160 degrees C. for about 2 hours. If several composites are laminated together to form a multi layer board this curing can take place during that lamination operation.

The critical rheological properties of the material formulated as described above which make it suitable for the present invention and which no other material previously used for this purpose satisfied are:

1) it is photo-curable

5

2) the value of its Loss Angle Ratio at ambient temperature is about .4 (that is, it is greater than about .1 and less than about 1.0)

3) The value of its Storage Shear Modulus G' at ambient temperature is about 3 times 10 to the 7th (that is it is greater than about 10 to the 7th and less than about ten to the eighth)

4) a Storage Shear Modulus G' at 125 degrees centigrade is about ten to the fifth power (that is the Storage Shear Modulus G' at temperatures of less than 150 degrees Celcius which is less than about ten to the sixth power.

Other examples of compositions which meet the requirements of the present invention are:

| Compound | Example | | | |
| | 2 | 3 | 4 | 5 |
| | parts | parts | parts | parts |
|---|---|---|---|---|
| EPON 1004 | 19.4 | 21 | 21 | 21 |
| Dow 485 | 19.4 | 21 | 21 | 21 |
| Acrylic Acid | 6.3 | 7 | 7 | 7 |
| BDMA | .4 | .42 | .42 | .42 |
| TMPTA | 18.7 | 5.4 | 5.4 | 5.4 |
| TBA | 1.1 | 1.2 | 1.2 | 1.2 |
| Benzoquinone | .01 | .01 | .01 | .01 |
| FC430 | .3 | .3 | .3 | .3 |
| PKHC | 27.1 | 30 | 30 | 15 |
| CAB-O-SIL | 7.3 | 8 | 4 | 20 |
| Cellosolve Acetate | sufficient to give desired consistency | | | |

Each of the above is formulated in the same way as the first example and the resulting compound will have the required rheological properties.

**Claims**

1. A photocurable adhesive characterised by having a Loss Angle Ratio at ambient temperature of between 0.1 and 1, and a Storage Shear Modulus G' (expressed in $dyne/cm^2 = 10^{-1}$ Pa) at ambient temperature between $10^7$ and $10^8$ and at temperatures above ambient and below 150°C less than $10^6$.

2. An adhesive according to claim 1, in which the Loss Angle Ratio is between about 0.3 and 0.7 at ambient temperature.

3. An adhesive according to claim 1 or 2, in which the Storage Shear Modulus G' is between $2 \times 10^7$ and $4 \times 10^7$ at ambient temperature.

4. A photo-curable adhesive according to claim 1, 2 or 3, comprising a bisphenol A-based epoxy resin having a molecular weight of about 1500 to 5000, an epoxidized novolac resin having a molecular weight of about 900 to 1500, monoethylenically unsaturated carboxylic acid, a catalyst, a polyethylenically unsaturated compound, a photoinitiator, phenoxy resin having a molecular weight of about 30,000 to about 200,000, and a thixotropic agent.

5. An adhesive according to claim 4, in which the proportion of A-based epoxy resin to novolac resin is between 4:1 and 1:4.

6. An adhesive according to claim 5, in which said proportion is substantially 1:1.

7. An adhesive according to claim 4, 5 or 6, in which the carboxylic acid is sufficient to react 20 to 100% of the epoxide functional groups.

8. An adhesive according to claim 7, in which the carboxylic acid is sufficient to react 75% of the epoxide functional groups.

9. An adhesive according to any of claims 4 to 8, in which the polyethylenically unsaturated compound is present in the amount of 10 to 25% by weight of the non-volatile components of the composition.

10. An adhesive according to any of claims 4 to 9, in which the photo-initiators is present in the amount of 0.1 to 10%, and preferably 0.1 to 5% by weight of the non-volatile components of the composition.

11. An adhesive according to any of claims 4 to 10, in which the phenoxy resin is a bisphenol A-based phenoxy resin.

12. An adhesive according to claim 11, in which the phenoxy resin is a bisphenol A-epichlorohydrin phenoxy.

13. An adhesive according to claim 11 or 12, in which the phenoxy is present in the amount of about 15 to 40% by weight of the non-volatile components of the composition.

14. An adhesive according to claim 13, in which the phenoxy amount is in the range 20 to 30%.

15. An adhesive according to any of claims 4 to 14, in which the thixotropic agent is present in the amount of 2 to 20%, and preferably 4 to 18%, by weight of the non-volatile components of the composition.

16. An encapsulated wire circuit board consisting of a rigid base plane (20 to 21), a layer (24) of glass epoxy pre-preg covering said base plane, and insulated wires (50) encapsulated in a layer (41 or 42) of photo-cured adhesive covering said epoxy pre-preg, the adhesive being according to any preceding claim.

17. An encapsulated wire circuit board in which a plurality of insulated wires (50) are attached to a rigid substrate (20; 21) by an adhesive layer (41; 42) formed from a photo-curable adhesive according to any of claims 1 to 15.

**Patentansprüche**

1. Photohärtbarer Kleber, gekennzeichnet durch ein Verlustwinkelverhältnis (Loss Angle Ratio) bei Raumtemperatur zwischen 0,1 und 1, und einen Speicherschermodul G' (Storage Shear Modulus) (ausgedrückt in dyn/cm$^2$=10$^{-1}$ Pa) bei Raumtemperatur zwischen 10$^7$ und 10$^8$ und bei Temperaturen über Raumtemperatur und unter 150°C von weniger als 10$^6$.

2. Kleber nach Anspruch 1, bei welchem das Verlustwinkelverhältnis zwischen ungefähr 0,3 und 0,7 bei Raumtemperatur liegt.

3. Kleber nach Anspruch 1 oder 2, bei welchem der Speicherschermodul G' zwischen 2 · 10$^7$ und 4 · 10$^7$ bei Raumtemperatur liegt.

4. Photohärtbarer Kleber nach Anspruch 1, 2 oder 3, welcher ein Epoxyharz auf Bisphenol A-Basis mit einem Molekulargewicht von ungefähr 1500 bis 5000, ein epoxydiertes Novolakharz mit einem Molekulargewicht von ungefähr 900 bis 1500, monoethylenisch ungesättigte Karbonsäure, einen Katalysator, eine polyethylenisch ungesättigte Verbindung, einen Photoinitiator, Phenoxyharz mit einem Molekulargewicht von ungefähr 30 000 bis ungefähr 20 000 und ein Thixotropiermittel umfaßt.

5. Kleber nach Anspruch 4, bei welchem das Verhältnis von Epoxyharz auf A-Basis zu Novolakharz zwischen 4:1 und 1:4 liegt.

6. Kleber nach Anspruch 5, bei welchem das Verhältnis im wesentlichen 1:1 ist.

7. Kleber nach Anspruch 4, 5 oder 6, bei welchem die Karbonsäure ausreichend ist, 20 bis 100% der epoxy-funktionellen Gruppen zur Reaktion zu bringen.

8. Kleber nach Anspruch 7, bei welchem die Karbonsäure ausreichend ist, 75% der epoxy-funktionellen Gruppen zur Reaktion zu bringen.

9. Kleber nach irgendeinem der Ansprüche 4 bis 8, bei welchem die polyethylenisch ungesättigte Verbindung in einer Menge von 10 bis 25 Gewichtsprozent der nicht-flüchtigen Komponenten der Zusammensetzung zugegen ist.

10. Kleber nach irgendeinem der Ansprüche 4 bis 9, bei welchem der Photoinitiator in einer Menge von 0,1 bis 10 Gewichtsprozent und vorzugsweise 0,1 bis 5 Gewichtsprozent der nicht-flüchtigen Komponenten der Zusammensetzung zugegen ist.

11. Kleber nach irgendeinem der Ansprüche 4 bis 10, bei welchem das Phenoxyharz ein Phenoxyharz auf Bisphenol A-Basis ist.

12. Kleber nach Anspruch 11, bei welchem das Phenoxyharz ein Bisphenol A-Epichlorhydrin-Phenoxyharz ist.

13. Kleber nach Anspruch 11 oder 12, bei welchem das Phenoxyharz in einer Menge von ungefähr 15 bis 40 Gewichtsprozent der nicht-flüchtigen Komponenten der Zusammensetzung zugegen ist.

14. Kleber nach Anspruch 13, bei welchem die Phenoxymenge im Bereich von 20 bis 30% ist.

15. Kleber nach irgendeinem der Ansprüche 4 bis 14, bei welchem das Thixotropiermittel in einer Menge von 2 bis 20 Gewichtsprozent und vorzugsweise 4 bis 18 Gewichtsprozent der nicht-flüchtigen Komponenten der Zusammensetzung zugegen ist.

16. Gekapselte Leiterplatte, bestehend aus einer starren Basisebene (20 bis 21), einer Schicht (24) aus Glas-Epoxy-Prepreg, welche die Basisebene abdeckt, und isolierten Drähten (50), welche in einer das Epoxy-Prepreg abdeckenden Schicht (41 oder 42) aus photogehärtetem Kleber gekapselt sind, wobei der Kleber nach irgendeinem der vorstehenden Ansprüche ist.

17. Gekapselte Leiterplatte, bei welcher eine Anzahl von isolierten Drähten (50) an einem starren Substrat (20; 21) durch eine Kleberschicht (41; 42), welche aus einem photohärtbaren Kleber nach irgendeinem der Ansprüche 1 bis 15 gebildet ist, angebracht sind.

**Revendications**

1. Adhésif photodurcissable, caractérisé en ce qu'il comporte un rapport d'angles de pertes à la

7

température ambiante compris entre 0,1 et 1, et un module de cisaillement de stockage G' (exprimé en dynes/cm$^2$=10$^{-1}$ Pa) situé entre 10$^7$ et 10$^8$ à la température ambiante et inférieur à 10$^6$ à des températures supérieures à la température ambiante et inférieures à 150°C.

2. Adhésif selon la revendication 1, dans lequel le rapport d'angles de perte est compris entre environ 0,3 et 0,7 à la température ambiante.

3. Adhésif selon la revendication 1 ou 2, dans lequel le module de cisaillement de stockage G' est compris entre 2×10$^7$ et 4×10$^7$ à la température ambiante.

4. Adhésif photodurcissable selon la revendication 1, 2 ou 3, comportant une résine époxy à base de bisphénol A, possédant un poids moléculaire compris entre environ 1500 et 5000, une résine novolaque époxydée, possédant un poids moléculaire compris entre environ 900 et 1500, de l'acide carboxylique non saturé par du monoéthylène, un catalyseur, un composé non saturé par du polyéthylène, un initiateur photochimique, une résine phénoxy possédant un poids moléculaire compris entre environ 30 000 et environ 200 000, et un agent thixotrope.

5. Adhésif selon la revendication 4, dans lequel la proportion de résine époxy à base de bisphénol A à la résine novolaque est comprise entre 4:1 et 1:4.

6. Adhésif selon la revendication 5, dans lequel ladite proportion est égale sensiblement à 1:1.

7. Adhésif selon la revendication 4, 5 ou 6, dans lequel l'acide carboxylique est présent en une quantité suffisante pour faire réagir 20 à 100% des groupes fonctionnels époxy.

8. Adhésif selon la revendication 7, dans lequel l'acide carboxylique est présent en une quantité suffisante pour faire réagir 75% des groupes fonctionnels époxy.

9. Adhésif selon l'une quelconque des revendications 4 à 8, dans lequel le composé non saturé par du polyéthylène est présent en une quantité comprise entre 10 et 25% en poids des composants non volatils de la composition.

10. Adhésif selon l'une quelconque des revendications 4 à 9, dans lequel les initiateurs photochimiques sont présents en une quantité comprise entre 0,1 et 10% et de préférence entre 0,1 et 5% en poids des composés non volatils de la composition.

11. Adhésif selon l'une quelconque des revendications 4 à 10, dans lequel la résine phénoxy est une résine phénoxy à base de bisphénol A.

12. Adhésif selon la revendication 11, dans lequel la résine phénoxy est une résine phénoxy à base de bisphénol A-épichlorhydrine.

13. Adhésif selon la revendication 11 ou 12, dans lequel la résine phénoxy est présente en une quantité comprise entre environ 15 et 40% en poids des composés non volatils de la composition.

14. Adhésif selon la revendication 13, dans lequel la quantité de résine époxy est comprise dans la gamme de 20 à 30%.

15. Adhésif selon l'une quelconque des revendications 4 à 14, dans lequel l'agent thixotropique est présent en une quantité comprise entre 2 et 20% et de préférence entre 4 et 18% en poids des composants non volatils de la composition.

16. Plaquette à circuits imprimés à fils encapsulés, constituée par une plaque de base rigide (20 à 21), une couche (24) d'un préimprégné verre-époxy recouvrant ladite plaque de base, et des fils isolés (5) encapsulés dans une couche (41 ou 42) d'un adhésif durci à la lumière, recouvrant ledit imprégné contenant un époxy, l'adhésif étant conforme à l'une quelconque des revendications précédentes.

17. Plaquette à circuits imprimés à fils encapsulés, dans laquelle une pluralité de fils isolés (50) sont fixés à un substrat rigide (20; 21) par une couche d'adhésif (41; 42) formée par un adhésif photodurcissable conformément à l'une quelconque des revendications 1 à 15.

8

FIG. 1

FIG. 2

FIG. 3

FIG. 4